# EUROPÄISCHE PATENTSCHRIFT

(11) **EP 0 455 839 B1**
(45) Veröffentlichungstag und Bekanntmachung des Hinweises auf die Patenterteilung: **26.01.1994**
(21) Anmeldenummer: 90106585.4
(22) Anmeldetag: 06.04.1990
(51) Int. Cl.: G01R 21/00

(54) **Vorrichtung zur Erfassung von Wirk- und/oder Blindleistung bei einem Wechselrichter mit eingeprägter Gleichspannung**
Circuit for measuring of the real and/or reactive power at a converter with impressed direct voltage
Circuit de mesure de la puissance réelle et réactive pour un convertisseur avec la tension continue appliquée

(43) Veröffentlichungstag der Anmeldung: 13.11.1991
(73) Patentinhaber: SIEMENS AKTIENGESELLSCHAFT, 80333 München (DE)
(72) Erfinder: Fries, Friedemann, Dipl.-Ing., W-8520 Erlangen (DE); Link, Ulrich, Dr.Ing., D-8523 Baiersdorf (DE)

(56) Entgegenhaltungen:
- DE-A- 3 504 623
- DE-A- 3 625 011

## Beschreibung

Die Erfindung bezieht sich auf eine Vorrichtung zur Erfassung von Wirk- und/oder Blindleistung an einer Phase eines Wechselrichters, wobei ein dem Phasenstrom entsprechendes Meßsignal zur Erfassung der Wirkleistung direkt bzw. zur Erfassung der Blindleistung nach Phasendrehung um π/2 einem mit einem Steuersignal betätigbaren Schalter aufgeschaltet wird, wobei die Wirk- bzw. Blindleistung einem geglätteten Ausgangssignal eines Überlagerungsgliedes entspricht.

Eine derartige Vorrichtung ist aus der DE-A-35 04 623 bekannt. Bei dieser Vorrichtung wird der Schalter, dem ein dem Phasenstrom entsprechendes Meßsignal zugeführt wird, mit dem den Schaltzustand des auf dieser Phase arbeitenden Wechselrichterschalters bestimmenden Schaltsignal betätigt. D.h., die Schalter werden mit den Steuersignalen des Wechselrichters, die mittels eines Steuersatzes erzeugt werden, angesteuert.

Da zum einen die Ansteuerschaltungen der Wechselrichterventile und zum anderen diese selbst Verzögerungs- bzw. Schaltzeiten aufweisen, liegt zwischen den Schaltbefehlen bzw. Steuersignalen für die Stromrichterventile des Wechselrichters und der Ausführung durch diese, also der Änderung von Schaltzuständen der Wechselrichterventile, eine u.U. erhebliche Totzeit, die beispielsweise bei Bipolartransistoren 20 µsec. oder mehr betragen kann. Hierdurch entsteht, insbesondere bei höheren Pulsfrequenzen des Wechselrichters, ein recht großer Meßfehler.

Der Wechselrichter speist üblicherweise einen Drehstrommotor. Die diesem zugeführten Wirk- und Blindleistungen und damit auch die gemessenen Wirk- und Blindleistungssignale sind bei Leerlauf bzw. bei niedrigen Umrichter-Ausgangsfrequenzen niedrig. So beträgt z.B. die einem Motor zugeführte Wirkleistung im Leerlauf nur wenige Prozent des Wertes im Nenn-Betriebspunkt. Wenn die gemessenen Leistungssignale nach einer Analog-Digital-Wandlung digital weiterverarbeitet werden sollen und der eingesetzte Analog-Digital-Wandler nur eine begrenzte Auflösung aufweist, so wird in vielen Fällen die erzielte Genauigkeit für eine sinnvolle Weiterverarbeitung der Meßwerte nicht ausreichen. Wenn der umrichtergespeiste Motor zeitweilig bis zur doppelten Nennleistung belastet werden kann, hat die Normierung des Analog-Digital-Wandlers so zu erfolgen, daß bei doppelter Nennleistung noch kein Überlauf auftritt. Dadurch können aber die Wirk- und/oder Blindleistungssignale bei niedriger Umrichter-Ausgangsfrequenz nicht einwandfrei in digitale Werte umgewandelt werden, die in einem Mikroprozessor einer Regelung verarbeitet werden können.

Der Erfindung liegt nun die Aufgabe zugrunde, eine Vorrichtung zur Erfassung von Wirk- und/oder Blindleistung bei einem Wechselrichter mit eingeprägter Zwischenkreisspannung anzugeben, bei der ein Meßfehler durch Totzeiten der Ansteuerschaltung und durch Schaltzeiten der Wechselrichterventile vermieden wird. Außerdem soll die Möglichkeit bestehen, trotz eines preiswerten handelsüblichen Analog-Digital-Wandlers mit niedriger Auflösung, diese gemessenen Leistungssignale bei niedrigen Wirk- bzw. Blindleistungen genau auswerten zu können.

Diese Aufgabe wird erfindungsgemäß gelöst durch eine Vorrichtung mit den Merkmalen des Anspruchs 1. Dadurch, daß anstelle der Steuersignale für die Ventile des Wechselrichters die tatsächlichen Schaltzustände der Ventile, also die binären Werte der Ausgangsspannung der jeweiligen Umrichterphase, zur Erfassung von Wirk- und/oder Blindleistung verwendet werden, kann das Meßsignal nicht mehr durch Totzeiten von Ansteuerschaltungen und/oder Schaltzeiten der Wechselrichterventile verfälscht werden. Diese binären Werte der Ausgangsspannung der jeweiligen Umrichterphasen werden mittels einer Erfassungseinrichtung erfaßt, die eingangsseitig mit einer Phase des Wechselrichters und einer Zwischenkreisschiene verbunden ist. Vorteilhafte Ausgestaltungen der Erfassungseinrichtung sind den Unteransprüchen 4 bis 7 zu entnehmen.

Dadurch, daß die Verstärkung der Überlagerungsglieder der Vorrichtung zur Erfassung von Wirk- und/oder Blindleistungen in Stufen umschaltbar ist, wobei die Umschaltung in Abhängigkeit des Ausgangssignals des Überlagerungsgliedes mittels eines Komparators mit Hysterese derart gesteuert wird, daß mit einem eine obere Schaltschwelle der Hysterese überschreitenden Ausgangssignal eine Verstärkung des Überlagerungsgliedes verkleinert wird, kann bei niedriger Leistung und durch einen großen Verstärkungsfaktor das gemessene Leistungssignal fein aufgelöst werden. D.h., für jede Stufe der Verstärkung der Überlagerungsglieder steht jedesmal der gesamte Meßbereich des preiswerten, handelsüblichen Analog-Digital-Wandlers mit niedriger Auflösung zur Verfügung. Da die analog-digital-gewandelten Leistungsmeßsignale von einem Mikroprozessor einer Regelung weiterverarbeitet werden, ist es vorteilhaft, daß der Mikroprozessor die Umschaltung der Verstärkung der Überlagerungsglieder mit Hilfe einer taktgesteuerten Speicherzelle steuert, wobei dem Mikroprozessor und der taktgesteuerten Speicherzelle das Ausgangssignal des Komparators zugeführt wird.

Zur weiteren Erläuterung der Erfindung wird auf die Zeichnung Bezug genommen, in der ein Ausführungsbeispiel einer Vorrichtung zur Erfassung von Wirk- und/oder Blindleistung eines Wechselrichters schematisch veranschaulicht ist.
- Figur 1: zeigt einen Wechselrichter mit einer Vorrichtung zur Erfassung von Wirk- und/oder Blindleistung, in
- Figur 2: ist eine Einrichtung zur Erhöhung der Genauigkeit der Vorrichtung zur Erfassung von Wirk- und/oder Blindleistung dargestellt und in den
- Figuren 3 bis 6: sind jeweils vorteilhafte Ausführungsformen der Erfassungeinrichtung veranschaulicht.

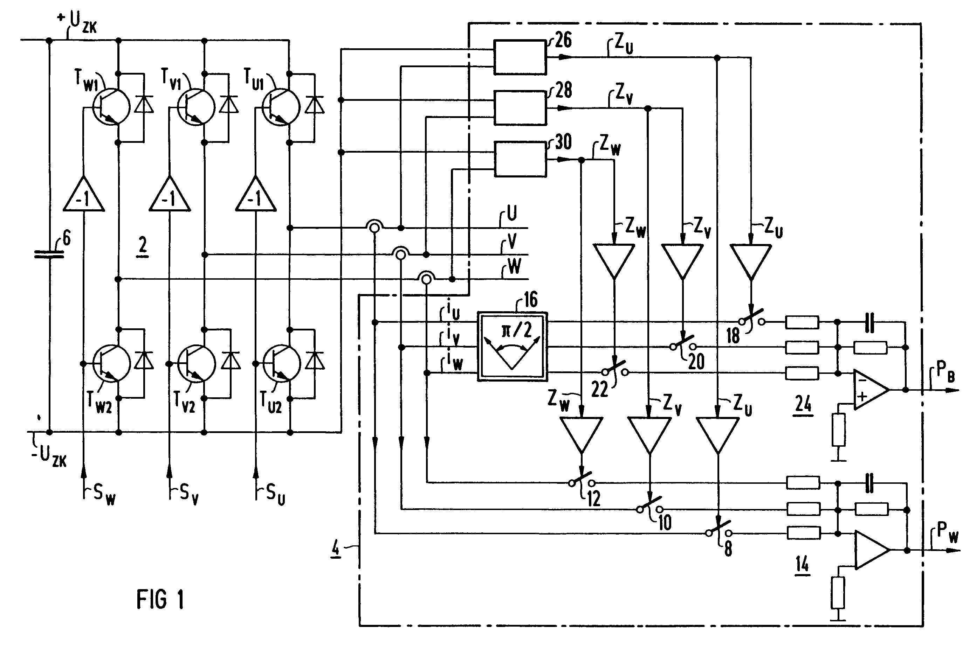

In Figur 1 ist ein Pulswechselrichter 2 mit einer Vorrichtung 4 zur Erfassung von Wirk- und/oder Blindleistung P_{W} und/oder P_{B} dargestellt. Eingangsseitig ist der Pulswechselrichter 2 elektrisch parallel mit einem Spannungszwischenkreis 6 verbunden. Dieser Spannungszwischenkreis 6 und der Pulswechselrichter 2 sind Bestandteile eines nicht näher dargestellten Umrichters.

Im Pulswechselrichter 2 ist jeder Ausgang U, V und W jeweils über ein Stromrichterventil T_{U1}, T_{U2}, T_{V1}, T_{V2}, T_{W1} und T_{W2} alternierend mit der positiven bzw. negativen Spannungsschiene +U_{ZK} bzw. -U_{ZK} des Spannungszwischenkreises 6 verbindbar, dessen von einem Netzstromrichter gelieferte Zwischenkreisspannung über den Kondensator konstant gehalten wird. Die Ansteuersignale für die Stromrichterventile T_{U1} bis T_{W2} sind mit S_{U}, Sᵥ und S_{W} bezeichnet. In jedem Stromrichterventil T_{U1} bis T_{W2} sind den einzelnen Transistoren Freilaufdioden elektrisch parallel geschaltet. Weitere selbstverständliche Einzelheiten (Treiberstufen, Mittel zur Potentialtrennung, Steuersatz, etc.) sind in dieser Figur 1 wegen der Übersichtlichkeit nicht dargestellt. Über geeignete Meßglieder werden an den Pulsumrichterausgängen U, V und W Meßwerte i_{U}, i_{V} und i_{W} für die Phasenströme gebildet. Diese Meßwerte i_{U}, i_{V} und i_{W} sind der Vorrichtung 4 zur Erfassung von Wirk- und/oder Blindleistung P_{W} und /oder P_{B} zugeführt.

In der Vorrichtung 4 ist der jeweilige Meßwert i_{U}, i_{V} und i_{W} zur Erfassung der Wirkleistung P_{W} einem Schalter 8, 10 und 12 zugeführt, wobei jeder Schalter 8, 10 und 12 mittels eines Schaltzustands-Signals Z_{U}, Z_{V} und Z_{W} des der entsprechenden Phase U, V und W zugeordneten Stromrichterventils T_{U1} bis T_{W2} betätigt wird. An den Ausgängen dieser Schalter 8, 10 und 12 stehen nunmehr Ausgangssignale an, die pulsbreitenmodulierte Werte für die Wirkleistung dieses Ausgangs darstellen. Der entsprechende Meßwert P_{W} für den gesamten Wechselrichter 2 wird gebildet, indem die an den Schaltern 8, 10 und 12 anstehenden pulsbreitenmodulierten Werte in einem Überlagerungsglied 14 zum resultierenden Wirkleistungswert P_{W} addiert und gemittelt werden. Die Glättung des oberschwingungsbehafteten Wertes der Momentan-Wirkleistung P_{W} geschieht mittels der RC-Beschaltung des Operationsverstärkers des Überlagerungsgliedes 14.

Zur Erfassung der Blindleistung P_{B} kann auf gleiche Weise vorgegangen werden, wobei es lediglich erforderlich ist, die Meßsignale i_{U}, i_{V} und i_{W} zunächst mittels eines Phasendrehers 16 in ihrer Phasenlage um 90° zu drehen. Die auf diese Weise phasenverschobenen Meßwerte werden entsprechenden Schaltern 18, 20 und 22 zugeführt, die ebenfalls mit den den Schaltzustand der Stromrichterventile T_{U1} bis T_{W2} bestimmenden Signalen Z_{U}, Z_{V} und Z_{W} betätigt werden. Ein anschließendes Überlagerungsglied 24, das zur Erreichung einer Glättung durch einen Operationsverstärker mit RC-Beschaltung ausgeführt ist, liefert dann den Meßwert für die Momentan-Blindleistung P_{B}.

Anstelle der Analogschalter 8, 10, 12, 18, 20 und 22 und anstelle der analogen Überlagerungsglieder 14 und 24 können entsprechende Digitalbausteine verwendet werden.

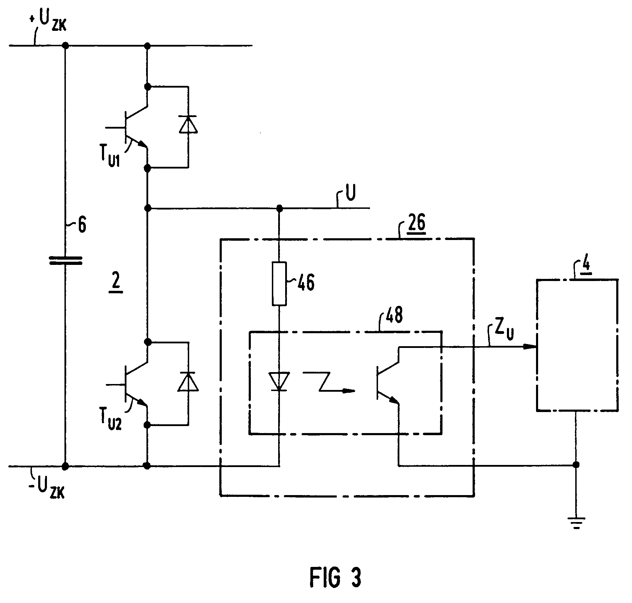

Zur Generierung der Schaltzustands-Signale Z_{U}, Z_{V} und Z_{W} für die Schalter 8, 10, 12, 18, 20 und 22 sind pro Phase U bzw. V bzw. W eine Erfassungseinrichtung 26 bzw. 28 bzw. 30 vorgesehen. Diese Erfassungseinrichtungen 26, 28 und 30 sind alle gleich aufgebaut, so daß im folgenden nur noch eine Erfassungseinrichtung 26 als Repräsentative genannt wird. Die Erfassungseinrichtung 26 ist eingangsseitig mit einem Pulswechselrichterausgang U und mit der negativen Spannungsschiene -U_{ZK} des Spannungszwischenkreises 6 verknüpft. Die Erfassungseinrichtung 26 kann eingangsseitig auch mit einem Ausgang U des Wechselrichters 2 und der positiven Spannungsschiene +U_{ZK} des Spannungszwischenkreises 6 verknüpft sein, wobei dann am Ausgang der Erfassungseinrichtung 26 ein Inverter vorgesehen sein muß, wenn das Schaltzustands-Signal Z_{U} der dargestellten Vorrichtung 4 zur Erfassung der Wirk- und/oder Blindleistung P_{W} und/oder P_{B} zugeführt werden soll. Ausführungsformen der Erfassungseinrichtung 26 sind in den Figuren 3 bis 6 näher dargestellt.

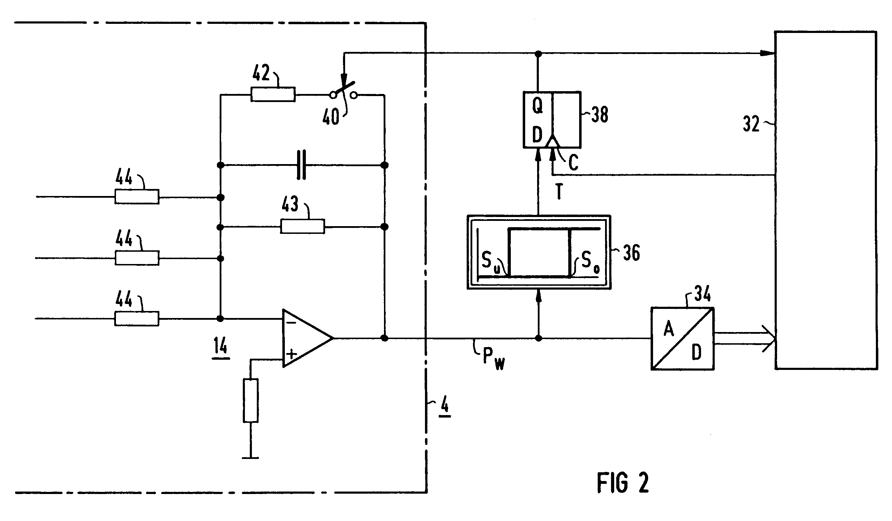

In Figur 2 ist eine Einrichtung zur Erhöhung der Genauigkeit der Vorrichtung 4 zur Erfassung der Wirk- und/oder Blindleistung P_{W} und/oder P_{B} dargestellt. Da der Wechselrichter 2 üblicherweise eine Last, insbesondere einen Drehstrommotor, speist, ist für die Regelung und Steuerung der Last eine Regel- und Steuereinrichtung vorhanden, die vorteilhafterweise mit einem Mikroprozessor 32 ausgestattet ist. Damit der Mikroprozessor 32 die ermittelten Wirk- und/oder Blindleistungs-Meßwerte P_{W} und/oder P_{B} weiterverarbeiten kann, müssen diese Werte P_{W} und P_{B} analog-digital-gewandelt werden. Als Analog-Digital-Wandler ist beispielsweise ein handelsüblicher 8-bit Analog-Digital-Wandler 34 vorgesehen. Damit über den gesamten Meßbereich der Wirk- und Blindleistung P_{W} und P_{B} die Genauigkeit für eine sinnvolle Weiterverarbeitung der Meßwerte ausreicht, ist die Verstärkung des Überlagerungsgliedes 14 und 24 in mehreren Stufen umschaltbar ausgeführt. In Figur 2 ist aus Übersichtlichkeitsgründen von der Vorrichtung 4 nur das Überlagerungsglied 14 dargestellt.

Das Ausgangssignal P_{W} des Überlagerungsgliedes 14 ist einerseits dem Analog-Digital-Wandler 34 und andererseits einem Komparator 36 mit Hysterese zugeführt. Der Ausgang des Analog-Digital-Wandlers 34 ist mit dem Mikroprozessor 32 einer nicht näher dargestellten Regelungs- und Steuereinrichtung und der Ausgang des Komparators 36 mit einem Eingang D einer taktgesteuerten Speicherzelle 38 verbunden. Der Ausgang Q dieser taktgesteuerten Speicherzelle 38 (taktzustandsgesteuertes D-Flip-Flop) ist einerseits mit einem Betätigungseingang eines Schalters 40 und andererseits mit dem Mikroprozessor 32 verknüpft. Dem Takteingang C der taktgesteuerten Speicherzelle 38 sind Taktsignale T vom Mikroprozessor 32 zugeführt.

Der Schalter 40 ist elektrisch in Reihe mit einem Widerstand 42 geschaltet. Diese Reihenschaltung ist elektrisch parallel zur RC-Beschaltung des Operationsverstärkers des Überlagerungsgliedes 14 geschaltet. Aus Übersichtlichkeitsgründen ist nur eine Reihenschaltung, bestehend aus dem Widerstand 42 und dem Schalter 40, dargestellt, wodurch das Überlagerungsglied 14 nur zwei Verstärkungsstufen aufweist. Die Verstärkung des Überlagerungsgliedes 14 ergibt sich aus dem Verhältnis des Widerstandes 43 zum Widerstand 44 bzw. bei geschlossenem Schalter 40 des wirksamen Widerstands der Parallelschaltung der Widerstände 42 und 43 zum Widerstand 44. Mittels des Widerstandes 42 und eines Schalters kann jede beliebige Verstärkung umschaltbar eingestellt werden, wobei die Umschaltung in Abhängigkeit des Ausgangssignals P_{W} des Überlagerungsgliedes 14 mittels des Komparators 36 und des taktzustandsgesteuerten D-Flip-Flop 38 gesteuert wird.

Sobald das Ausgangssignal P_{W} des Überlagerungsgliedes 14 von kleinen Werten kommend die obere Schaltschwelle Sₒ des Komparators 36 überschreitet, wechselt das Signal am Ausgang des Komparators 36 seinen logischen Pegel "0" auf "1". Wenn das Ausgangssignal P_{W} digitalisiert und im Mikroprozessor 32 eingelesen ist, gibt der Mikroprozessor 32 mittels Taktsignale T das D-Flip-Flop 38 frei, wodurch an seinem Ausgang Q ein Signal mit logischem Pegel "1" erscheint. Dieses Signal bewirkt das Schließen des Schalters 40 und wird dem Mikroprozessor 32 zugeführt, damit der Prozessor 32 über die momentan wirksame Verstärkung des Überlagerungsgliedes 14 informiert ist. Durch Schließen des Schalters 40 wird die Verstärkung auf die kleinere der beiden hier dargestellten Verstärkungen umgeschaltet. Wenn das Ausgangssignal P_{W} von großen Werten kommend die untere Schaltschwelle Sᵤ des Komparators 36 überschreitet, so wechselt das Signal am Ausgang des Komparators 36 seinen logischen Pegel von "1" auf "0", wodurch der Schalter 40 geöffnet wird und die Verstärkung des Überlagerungsgliedes 14 auf den größeren Verstärkungswert umgeschaltet wird. Damit wird ein Überlauf des Analog-Digital-Wandlers 34 verhindert, der das Signal P_{W} für die weitere Verarbeitung aufbereitet. Außerdem kann der Analog-Digital-Wandler 34 das Meßsignal P_{W} sehr fein auflösen, d.h., der Meßbereich des Analog-Digital-Wandlers 34 kann bei jeder Verstärkungsstufe voll ausgenutzt werden.

In Figur 3 ist ein erstes Ausführungsbeispiel der Erfassungseinrichtung 26 im einzelnen dargestellt. Da aus Gleichheitsgründen nur eine Erfassungseinrichtung 26 dargestellt ist, ist vom Pulswechselrichter 2 auch nur die entsprechende Phase U dargestellt. Die Erfassungseinrichtung 26 besteht aus einer Reihenschaltung eines Widerstandes 46 (Strombegrenzungswiderstand) und eines Optokopplers 48, insbesondere eines schnellen Optokopplers. Der Sender des Optokopplers 48 befindet sich auf dem Potential des Ausgangs U des Wechselrichters 2 und der Empfänger des Optokopplers 48 auf dem Potential der Vorrichtung 4. Aus Gründen der Störsicherheit ist der Optokoppler 48 direkt mit einer Spannungsschiene +U_{ZK} bzw. -U_{ZK} des Spannungszwischenkreises 6 verbunden. Dadurch wird eine hohe du/dt-Beanspruchung des Optokopplers 48 vermieden. Da die effektive Spannung zwischen dem Phasenausgang U und der negativen Schiene -U_{ZK} des Zwischenkreises 6 um Größenordnungen größer ist als die Durchlaßspannung des Optokopplers 48, der einen Primärstrom von einigen mA benötigt, tritt am Widerstand 46 nennenswerte Verlustleistung auf.

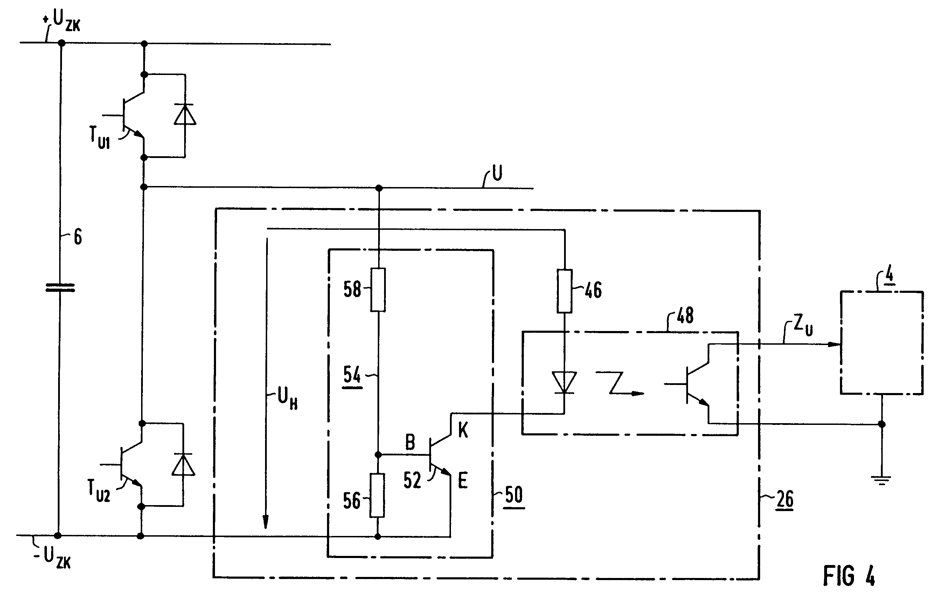

In der Figur 4 ist eine Weiterbildung der Ausführungsform der Erfassungseinrichtung 26 nach Figur 3 näher dargestellt. In dieser Ausführungsform wird der Optokoppler 48 nicht direkt über den Ausgang U des Wechselrichters 2 geschaltet, sondern mittels einer Transistorschaltung 50. Der Optokopppler 48 wird aus einer Hilfsspannungsquelle U_{H} gespeist. Die Transistorschaltung 50 besteht beispielsweise aus einem Kleinsignal-Bipolartransistor 52, an dessen Basis B ein Spannungsteiler 54 geschaltet ist, der einerseits mit dem Ausgang U des Wechselrichters 2 und andererseits mit der negativen Spannungsschiene -U_{ZK} des Spannungszwischenkreises 6 verknüpft ist. Der Kollektor K ist mit dem Sender des Optokopplers 48 elektrisch leitend verbunden. Durch die bei Kleinsignal-Bipolartransistoren hohe Stromverstärkung wird nur ein geringer Basisstrom für den Transistor 52 benötigt, so daß auch nur geringe Verluste in den Widerständen 56 und 58 des Spannungsteilers 54 anfallen. Da der Transistor 52 abhängig von der Zwischenkreisspannung mit sehr unterschiedlichen Basisströmen gespeist wird und deshalb zumindest bei hohen Zwischenkreisspannungen infolge eines höheren Basisstroms stark gesättigt ist, kann der Transistor 52 nur langsam ausschalten.

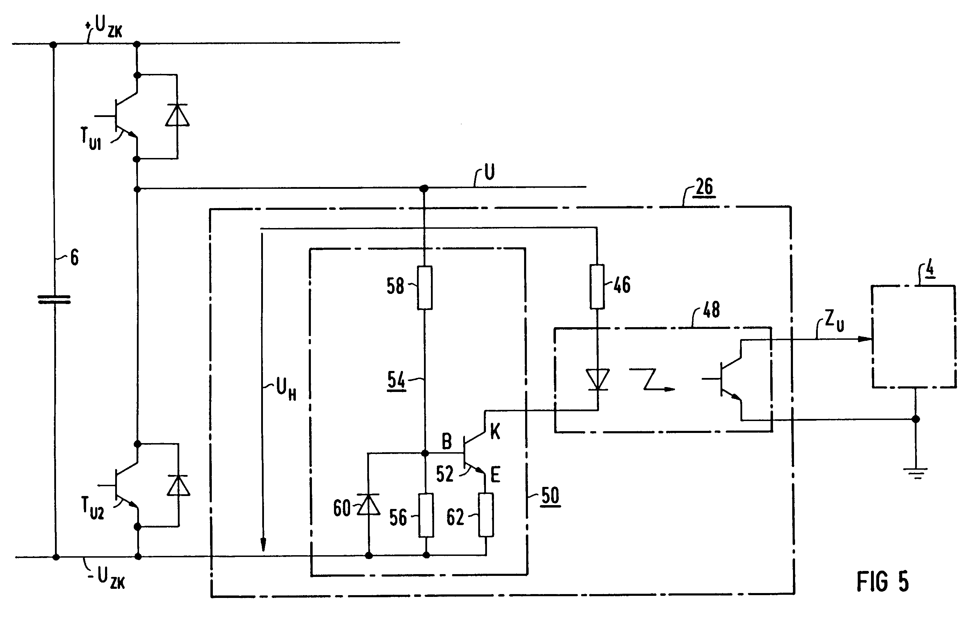

In Figur 5 ist eine Weiterbildung der Ausführungsform der Erfassungseinrichtung 26 nach Figur 4 veranschaulicht. Die Transistorschaltung 50 ist um eine Diode 60 und einen Stromquellenwiderstand 62 erweitert. Die schnelle Diode 60 ist elektrisch parallel zur Basis-Emitter-Strecke des Transistors 52 geschaltet und der Stromquellenwiderstand 62 ist elektrisch leitend mit dem Emitter E verknüpft. Damit arbeitet diese Transistorschaltung 50 als eine ein- und ausschaltbare Stromquelle. Dadurch arbeitet der Transistor 52 bei ausreichend kleinem Widerstand 46 nie im gesättigten Zustand und schaltet folglich sehr schnell ab. Voraussetzung für das schnelle Ein- und Abschalten ist eine schnelle Diode 60.

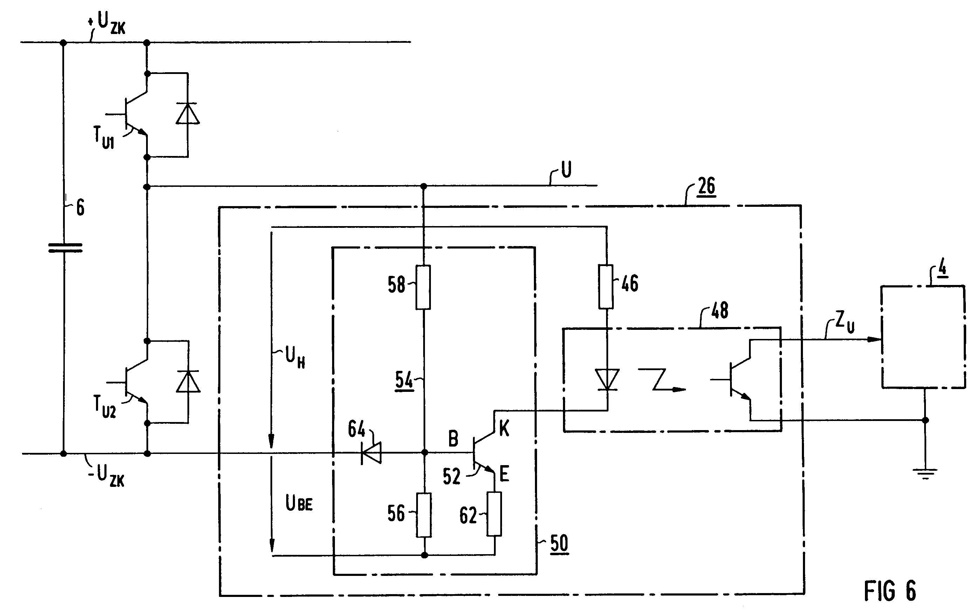

In Figur 6 ist eine alternative Ausführungsform zur Ausführungsform der Erfassungseinrichtung 26 nach Figur 5 dargestellt. Anstelle der schnellen Diode 60 wird eine Spannungsquelle U_{BE} und eine Entkopplungsdiode 64 verwendet. Die Ersatzschaltung U_{BE} - 64 wirkt nach außen wie eine schnelle Diode 60. Diese Spannung U_{BE} und die Spannung U_{H}, die beide auf die negative Spannungsschiene -U_{ZK} des Spannungszwischenkreises 6 bezogen sind, können aus einer nicht näher dargestellten Ansteuereinrichtung für die unteren Stromrichterventile T_{U2}, T_{V2} und T_{W2} des Pulswechselrichters 2 abgeleitet werden, wodurch kein zusätzlicher Aufwand entsteht.

## Patentansprüche

1. Vorrichtung (4) zur Erfassung von Wirk- und/oder Blindleistung (P_{W}, P_{B}) an einer Phase (U, V, W) eines Wechselrichters (2), wobei ein dem Phasenstrom entsprechendes Meßsignal (i_{U}, i_{V}, i_{W}) zur Erfassung der Wirkleistung (P_{W}) direkt bzw. zur Erfassung der Blindleistung (P_{B}) nach Phasendrehung um π/2 einem mit einem Steuersignal betätigbaren Schalter (8, 10, 12 bzw. 18, 20, 22) aufgeschaltet wird, wobei die Wirk- bzw. Blindleistung (P_{W} bzw. P_{B}) einem geglätteten Ausgangssignal eines Überlagerungsgliedes (14 bzw. 24) entspricht, **dadurch gekennzeichnet,** daß als Steuersignal der tatsächliche Schaltzustand (Z_{U}, Z_{V}, Z_{W}) des auf diese Phase (U, V, W) arbeitenden Stromrichterventils (T_{U1}, T_{U2}, T_{V1}, T_{V2}, T_{W1}, T_{W2}) des Wechselrichters (2) vorgesehen ist, wobei dieses Schaltzustands-Signal (Z_{U}, Z_{V}, Z_{W}) mittels einer Erfassungseinrichtung (26, 28, 30) ermittelt wird, die eingangsseitig mit einem Ausgang (U, V, W) des Wechselrichters (2) und einer Zwischenkreisschiene (+U_{ZK} bzw. -U_{ZK}) verbunden ist.

2. Vorrichtung (4) nach Anspruch 1, **dadurch gekennzeichnet,** daß eine Verstärkung des Überlagerungsgliedes (14, 24) in Stufen umschaltbar ausgeführt ist, wobei die Umschaltung in Ahbängigkeit des Ausgangssignals (P_{W}, P_{B}) des Überlagerungsgliedes (14, 24) mittels eines Komparators (36) mit Hysterese derart gesteuert wird, daß mit einem eine obere Schaltschwelle (Sₒ) der Hysterese überschreitendem Ausgangssignal eine Verstärkung des Überlagerungsgliedes (14, 24) verkleinert wird.

3. Vorrichtung (4) nach Anspruch 2, **dadurch gekennzeichnet,** daß die Umschaltung der Verstärkung des Überlagerungsgliedes (14, 24) mittels eines Mikroprozessors (32) und einer taktgesteuerten Speicherzelle (38), denen ein Ausgangssignal (P_{W}, P_{B}) des Komparators (36) zugeführt sind, gesteuert wird.

4. Vorrichtung (4) nach Anspruch 1, **dadurch gekennzeichnet,** daß als Erfassungseinrichtung (26, 28, 30) eine Reihenschaltung, bestehend aus einem Widerstand (46) und einem Optokoppler (48), vorgesehen ist.

5. Vorrichtung (4) nach Anspruch 1, **dadurch gekennzeichnet,** daß die Erfassungseinrichtung (26, 28, 30) eingangsseitig aus einer Transistorschaltung (50) und ausgangsseitig aus einem aus einer Hilfsspannungsquelle (U_{H}) gespeisten Optokoppler (48) mit Vorwiderstand (46) besteht, wobei ein Transistor (52) der Transistorschaltung (50) den Optokoppler (48) schaltet.

6. Vorrichtung (4) nach Anspruch 5, **dadurch gekennzeichnet,** daß der Emitter (E) des Transistors (52) elektrisch leitend mit einem Stromquellenwiderstand (62) verbunden und eine Zenerdiode (60) elektrisch parallel zur Basis-Emitter-Strecke des Transistors (52) geschaltet ist.

7. Vorrichtung (4) nach Anspruch 5, **dadurch gekennzeichnet,** daß die Basis-Emitter-Strecke des Transistors (52) aus einer Spannungsquelle (U_{BE}) gespeist wird, wobei die Basis (B) des Transistors (52) mittels einer Entkopplungsdiode (64) mit der Spannungsquelle (U_{BE}) verbunden ist.

## Claims

1. Device (4) for detecting active power and/or reactive power (P_{W}, P_{B}) at a phase (U, V, W) of an inverter (2), whereby a measuring signal (i_{U}, i_{V}, i_{W}) corresponding to the phase current is applied for detecting the active power (P_{W}) directly or for detecting the reactive power (P_{B}) after phase rotation by π/2 to a switch (8, 10, 12 or 18, 20, 22) operable with a control signal, whereby the active power or reactive power (P_{W} or P_{B}) corresponds to a smoothed output signal of a superposition element (14 or 24), characterized in that as control signal the actual switching state (Z_{U}, Z_{V}, Z_{W}) of the converter valve (T_{U1}, T_{U2}, T_{V1}, T_{V2}, T_{W1}, T_{W2}) of the inverter (2) operating on this phase (U, V, W) is provided, whereby this switching-state signal (Z_{U}, Z_{V}, Z_{W}) is determined by means of a detection device (26, 28, 30) which is connected on the input side to an output (U, V, W) of the inverter (2) and an intermediate-circuit rail (+U_{ZK} or -U_{ZK}).

2. Device (4) according to claim 1, characterized in that a gain of the superposition element (14, 24) is designed so that it has stepped ratio selection, whereby the transfer is controlled in dependence upon the output signal (P_{W}, P_{B}) of the superposition element (14, 24) by means of a comparator (36) with hysteresis in such a way that a gain of the superposition element (14, 24) is reduced with an output signal exceeding an upper switching threshold (Sₒ) of the hysteresis.

3. Device (4) according to claim 2, characterized in that the transfer of the intensification of the superposition element (14, 24) is controlled by means of a microprocessor (32) and a clocked memory cell (38), to which there is supplied an output signal (P_{W}, P_{B}) of the comparator (36).

4. Device (4) according to claim 1, characterized in that there is provided as detection device (26, 28, 30) a series connection, comprising a resistance (46) and an optical coupler (48).

5. Device (4) according to claim 1, characterized in that the detection device (26, 28, 30) consists on the input side of a transistor circuit (50) and on the output side of an optical coupler (48) with series-resistance (46) supplied from an auxiliary voltage source (U_{H}), whereby a transistor (52) of the transistor circuit (50) connects the optical coupler (48).

6. Device (4) according to claim 5, characterized in that the emitter (E) of the transistor (52) is connected in an electroconductive manner to a current source resistance (62) and a Zener diode (60) is connected electrically in parallel with the base emitter path of the transistor (52).

7. Device (4) according to claim 5, characterized in that the base emitter path of the transistor (52) is supplied from a voltage source (U_{BE}), whereby the base (B) of the transistor (52) is connected to the voltage source (U_{BE}) by means of a decoupling diode (64).

## Revendications

1. Dispositif (4) pour déterminer la puissance réelle et/ou la puissance réactive (P_{W}, P_{B}) dans une phase (U,V,W) d'un onduleur (2), et dans lequel un signal de mesure (i_{U}, i_{V}, i_{W}), qui correspond au courant de phase, est appliqué directement, pour la détection de la puissance relative (P_{W}), ou après rotation de phase de π/2, pour la détection de la puissance réactive (P_{B}), à un interrupteur (8,10,12 ou 18,20,22), qui peut être actionné par un signal de commande, la puissance active ou la puissance réactive (P_{W} ou P_{B}) correspondant à un signal de sortie lissé d'un circuit de superposition (14 ou 24), caractérisé par le fait qu'il est prévu, en tant que signal de commande, l'état de commutation (Z_{U}, Z_{V}, Z_{W}) effectif de la valve de conversion de courant (T_{U1}, T_{U2}, T_{V1}, T_{V2}, T_{W1}, T_{W2}) de l'onduleur (2), qui travaille dans cette phase (U,V,W), ce signal d'état de commutation (Z_{U}, Z_{V}, Z_{W}) étant déterminé au moyen d'un dispositif de détermination (26,28,30), qui est relié côté entrée à une sortie (U,V,W) de l'onduleur (2) et à un circuit intermédiaire (+U_{ZK} ou -U_{ZK}).

2. Dispositif (4) suivant la revendication 1, caractérisé par le fait qu'une amplification du circuit de superposition (14,24) est exécutée d'une manière commutable selon des échelons, la commutation étant commandée avec hystérésis, en fonction du signal de sortie (P_{W}, P_{B}) du circuit de superposition (14,24), de telle sorte qu'une amplification du circuit de superposition (14,24) est réduite par un signal de sortie dépassant un seuil supérieur de commutation (Sₒ) de l'hystérésis.

3. Dispositif (4) suivant la revendication 2, caractérisé par le fait que la commutation de l'amplification du circuit de superposition (14,24) est commandée au moyen d'un microprocesseur (32) et d'une cellule de mémoire (38) commandée de façon cadencée, un signal de sortie (P_{W}, P_{B}) du comparateur (36) étant envoyé au microprocesseur et à la cellule de mémoire.

4. Dispositif (4) suivant la revendication 1, caractérisé par le fait qu'il est prévu, comme dispositif de détection (26,28,30), un circuit série constitué d'une résistance (46) et d'un optocoupleur (48).

5. Dispositif (4) suivant la revendication 1, caractérisé par le fait que le dispositif de détermination (26,28,30) est constitué, côté entrée, d'un circuit à transistors (50) et, côté sortie, d'un optocoupleur (48) alimenté par une source de tension auxiliaire (U_{H}) à résistance série (46), un transistor (52) du circuit à transistors (50) assurant le branchement de l'optocoupleur (48).

6. Dispositif (4) suivant la revendication 5, caractérisé par le fait que l'émetteur (E) du transistor (52) est relié d'une manière électriquement conductrice à une résistance (62) de la source de courant et qu'une diode Zener (60) est branchée électriquement en parallèle avec la section base-émetteur du transistor (52).

7. Dispositif (4) suivant la revendication 5, caractérisé par le fait que la section base-émetteur du transistor (52) est alimentée par une source de tension (U_{BE}), la base (B) du transistor (52) étant reliée à la source de tension (U_{B1}) par l'intermédiaire d'une diode de découplage (64).
